# FASCICULE DE BREVET EUROPEEN

(11) **EP 1 885 648 B1**
(45) Date de publication et mention de la délivrance du brevet: **29.08.2018**
(21) Numéro de dépôt: 06794468.6
(22) Date de dépôt: 29.05.2006
(51) Int. Cl.: B82B 3/00, B21B 1/00, H01J 9/02, H01J 1/304

(54) **PROCEDE DE REALISATION DE NANOSTRUCTURES**
VERFAHREN ZUR HERSTELLUNG VON NANOSTRUKTUREN
METHOD FOR MAKING NANOSTRUCTURES

(30) Priorité: 30.05.2005 FR 0551412
(43) Date de publication de la demande: 13.02.2008
(73) Titulaire: Commissariat à l'Énergie Atomique et aux Énergies Alternatives, 75015 Paris (FR)
(72) Inventeur: GOISLARD DE MONSABERT, Thomas, 38330 Saint Ismier (FR); DIJON, Jean, 38800 Champagnier (FR)
(74) Mandataire: Ahner, Philippe
(86) Numéro de dépôt international: PCT/FR2006/050489
(87) Numéro de publication internationale: WO 2007/003826

(56) Documents cités:
- WO-A-2004/063091
- US-A1- 2004 161 929
- GRAHAM A P ET AL: "Towards the integration of carbon nanotubes in microelectronics" DIAMOND AND RELATED MATERIALS, ELSEVIER SCIENCE PUBLISHERS, AMSTERDAM, NL, vol. 13, no. 4-8, avril 2004 (2004-04), pages 1296-1300, XP004507963 ISSN: 0925-9635 cité dans la demande

## Description

### DOMAINE TECHNIQUE

L'invention concerne un procédé de réalisation de nanostructures sur un support, notamment des nanostructures électriquement indépendantes. L'invention s'applique en particulier aux nanotubes émetteurs d'électrons dans les structures cathodiques pour écrans plats.

### ÉTAT DE LA TECHNIQUE ANTÉRIEURE

Les nanostructures auxquelles nous faisons référence ici sont des structures auto-assemblées et localisées par croissance catalytique sur un catalyseur supporté. Il peut s'agir par exemple de nanotubes, de nanofilaments ou de nanofils.

La croissance catalytique de nanostructures sur un catalyseur supporté impose d'utiliser, comme support du catalyseur, un matériau qui limite la diffusion du catalyseur en son sein, et notamment à la température de croissance.

Par ailleurs, si l'on souhaite obtenir des nanostructures électriquement adressables et électriquement indépendantes, le support du catalyseur doit être conducteur mais ne doit pas contacter électriquement les nanostructures entre-elles. Le support doit donc être discontinu, c'est-à-dire être conducteur électrique sous les structures auto-assemblées et isolant électrique (ou absent) entre les structures auto-assemblées.

Une méthode connue pour obtenir un tel support discontinu consiste à structurer le support à l'aide de techniques de lithographie électronique ou optique. Cependant, pour des structures auto-assemblées de faible dimension et/ou de forte densité, ces techniques peuvent s'avérer très coûteuses et partiellement efficaces.

L'obtention de nanostructures électriquement indépendantes sur un support est particulièrement intéressante dans le domaine des structures cathodiques, utilisées dans les dispositifs de visualisation par cathodo-luminescence excités par émission de champ et en particulier dans les écrans plats à émission de champ.

Les dispositifs de visualisation par cathodo-luminescence excités par émission de champ comprennent une cathode, qui émet des électrons, et une anode, en regard de la cathode, recouverte d'une couche luminescente. L'anode et la cathode sont séparées par un espace où le vide est fait.

Les cathodes utilisées sont souvent des structures cathodiques complexes de type diode ou de type triode. Les structures triodes possèdent une électrode supplémentaire appelée grille qui facilite l'extraction des électrons de la cathode. Plusieurs structures triodes ont déjà été envisagées dans l'art antérieur. On peut les classer en deux grandes familles en fonction de la position de la grille par rapport à la cathode.

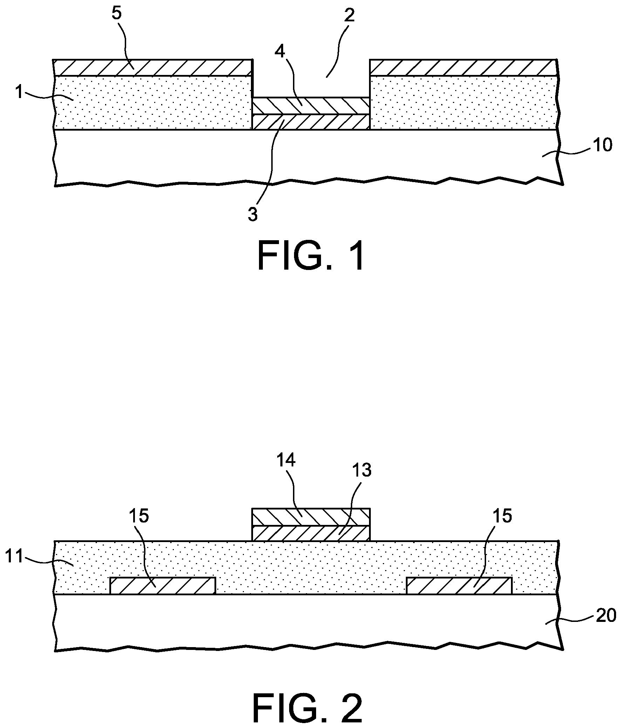

Une première famille de structures triodes regroupe les structures où la cathode est déposée au fond de trous réalisés dans une couche isolante et où la grille est située sur la couche isolante. Ces structures triodes sont appelées structures de type I. Un exemple d'une telle structure triode est décrite dans le document [**1**], référencé à la fin de la description, qui divulgue un procédé de fabrication d'un dispositif de visualisation par cathodo-luminescence excité par émission de champ et est illustrée dans la figure 1. La figure 1 représente, vue en coupe et de façon schématique, une structure de cathode de type I selon l'art connu, pour un dispositif de visualisation par cathodo-luminescence excité par émission de champ. Un seul dispositif d'émission est représenté sur cette figure. Une couche 1 en matériau électriquement isolant est percée d'un trou circulaire 2 et déposée sur un support 10. Au fond du trou 2 est disposée (sur la totalité du trou comme illustré dans la figure 1 ou localement) une couche conductrice 3 formant cathode et supportant une couche 4 de matériau émetteur d'électrons (par exemple une couche de nanostructures émettrices d'électrons telles que des nanotubes de carbone). La face supérieure de la couche d'isolant 1 supporte une couche métallique 5 formant grille d'extraction des électrons et entourant le trou 2.

Une deuxième famille de structures triodes regroupe des structures où la cathode est déposée sur une couche isolante et où la grille est située sous la couche isolante. Ces structures triodes sont appelées structures de type II. De telles structures triodes sont décrites dans les documents **[2]** et **[3].** La figure 2 représente, vue en coupe et de façon schématique, une structure de cathode de type II selon l'art connu, pour un dispositif de visualisation par cathodo-luminescence excité par émission de champ. Un seul dispositif d'émission est représenté sur cette figure. Une couche 11 en matériau électriquement isolant, déposée sur un support 20 supporte sur sa face inférieure une électrode de grille 15 constituée de deux parties encadrant une cathode 13 disposée sur la face supérieure de la couche 11 et supportant une couche 14 de matériau émetteur d'électrons.

Afin que les structures de cathodes de type I et II fonctionnent correctement au niveau de l'émission électronique, on peut complexifier l'empilement au niveau de la cathode en rajoutant, entre le conducteur de cathode et la couche émissive, une couche résistive dont l'objectif est de limiter le courant émis par les émetteurs individuels afin de rendre l'émission plus uniforme (voir le document **[4]).** La couche résistive a ainsi un rôle de régulateur de l'émission des électrons.

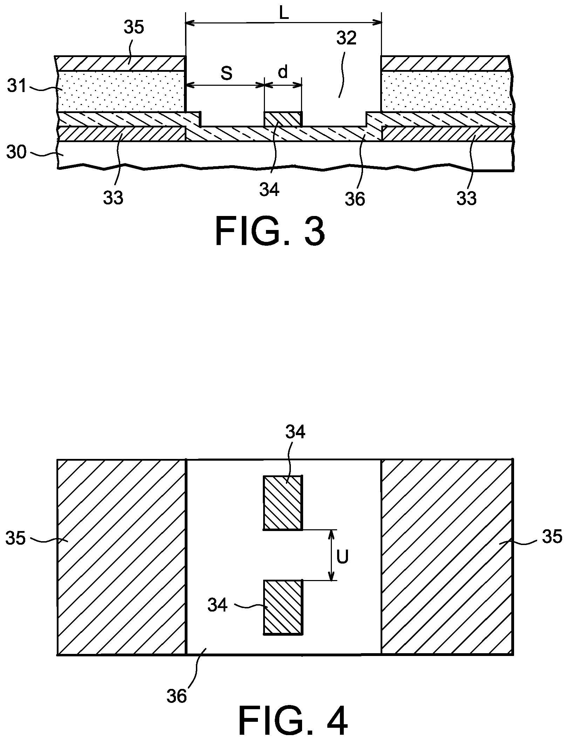

Une variante de réalisation d'une structure de type I est illustrée dans la figure 3. Selon cette figure, on peut voir que cette structure de cathode comprend, en superposition sur un support 30, une électrode de cathode 33 en deux parties dans un matériau conducteur, une couche résistive 36 recouvrant les deux parties de l'électrode de cathode 33 et la surface du support 30 située entre ces deux parties, une couche isolante 31 et une couche métallique 35 formant grille d'extraction des électrons. Un trou 32 de largeur L expose la couche résistive 36. Au centre du trou 32 et à une distance S de la couche de cathode 33, une couche de matériau émissif 34, formée à partir d'une zone de croissance, repose sur la couche résistive 36. La distance S est choisie pour avoir une longueur efficace de la couche résistive de l'ordre de S (et non de l'ordre de l'épaisseur de cette couche comme dans le cas S=0 (couche résistive sur couche cathode)), ce qui permet d'obtenir une résistance plus élevée à épaisseur et résistivité identiques de la couche résistive, et donc améliorer l'uniformité de l'émission. De préférence, la largeur d de la zone de croissance de la couche de matériau émissif 34 est faible par rapport à la largeur L du trou. Cela permet de limiter les possibilités de contact de la couche de matériau émissif avec l'électrode de grille, source de courant de fuite entre cathode et grille en fonctionnement. Ici, les parties de l'électrode de cathode 33 sont situées à l'aplomb de la grille d'extraction 35. Elles pourraient également être en retrait par rapport à l'aplomb de la grille 35. Le détail d'un procédé de réalisation de cette structure peut être trouvé dans le document **[4].** La zone de croissance peut être discontinue et structurée en plots comme le montre la figure 4 qui est une vue de dessus possible de la structure de cathode de la figure 3. Elle montre que la couche de matériau émissif 34 est répartie sur deux plots de croissance séparés d'une distance U qui est du même ordre de grandeur que la distance S. La répartition de la couche émissive en des plots séparés assure une certaine indépendance électrique des zones émettrices les unes par rapport aux autres et donc une action plus efficace de la couche résistive pour chaque plot.

US 2004/0161929 décrit un procédé de réalisation de nanostructures sur un support et une structure de cathode selon la préambule de la revendication 1.

[10] décrit un procédé de réalisation de nanostructures sur un support. 1

Idéalement, pour que la couche résistive joue pleinement son rôle individuellement pour chaque nanostructure, les nanostructures émettrices d'électrons devraient être isolées électriquement les unes des autres. Cependant, pour des raisons de coût, on ne réalise par lithographie optique que des structures dont la plus petite dimension est de l'ordre de 5 µm, tandis que le rayon des nanostructures émettrices n'est que de quelques nm ou quelques dizaines de nm.

Ainsi, dans l'art antérieur, on isole électriquement non pas chaque nanostructure émettrice, mais des groupes de nanostructures émettrices. Le problème d'uniformité du courant électrique n'est pas résolu au sein d'un même groupe de nanostructures émettrices, car le plot sur lequel elles reposent est conducteur.

Le but de l'invention est de proposer un procédé qui permette d'obtenir des nanostructures sur un support, et en particulier des nanostructures électriquement connectées et indépendantes, ledit procédé étant efficace et moins coûteux que les procédés connus de l'art antérieur.

De façon plus générale, le problème que cherche à résoudre l'invention est d'obtenir un bicouche structuré pour la croissance de nanostructures de façon alignée sans utiliser de masque de lithographie (dépôt et structuration de résine par insolation...), ni d'alignement de masque.

### EXPOSÉ DE L'INVENTION

Ce but est atteint par un procédé de réalisation de nanostructures sur un support selon la renvendication 1.

Dans notre invention, on entend par « couche barrière » une couche en un matériau limitant la diffusion du matériau catalyseur accolé à la couche barrière, notamment à la température de croissance des nanostructures sur le catalyseur.

Les nanostructures obtenues peuvent être des nanotubes, des nanofilaments ou des nanofils.

Pour l'étape de gravure, on utilise la couche de catalyseur comme masque de gravure. L'étape de gravure de la couche de surface dans les zones non couvertes par le catalyseur est une gravure sélective et anisotrope de la couche de surface en utilisant les particules de catalyseur comme masque de gravure. On poursuit la gravure jusqu' à ce que la couche de surface disparaisse dans les zones non couvertes par le catalyseur.

Avantageusement, la couche de surface est en matériau conducteur ou semi-conducteur et les nanostructures sont en un matériau conducteur ou semi-conducteur. On obtient ainsi des nanostructures électriquement indépendantes.

Avantageusement, le support comporte une couche résistive sur la face destinée à supporter la couche de surface. On entend par couche résistive une couche en un matériau ayant une résistivité et une épaisseur lui permettant de limiter ou de réguler le flux d'électrons le traversant. Dans le cas de nanostructures émettrices d'électrons, par exemple, la couche résistive permet de limiter ou de réguler le courant émis par les nanostructures, et ce d'autant plus que le courant est important, afin de rendre l'émission d'électrons plus uniforme.

Selon une variante, le support comporte une couche de matériau conducteur en contact avec la couche résistive. La couche de matériau conducteur peut par exemple être sous la couche résistive.

Avantageusement, au moins une partie de l'épaisseur de la couche résistive est gravée dans les zones où la couche de surface est gravée.

Selon un exemple, la structuration de la couche de catalyseur selon un motif est obtenue par fragmentation d'un film de catalyseur sur la couche de surface. Le film de catalyseur peut être initialement continu. Le film de catalyseur peut également être initialement discontinu, mais dans ce cas, l'étape de structuration par fragmentation de la couche de catalyseur n'est pas obligatoire.

Avantageusement, la fragmentation du film de catalyseur sur la couche de surface est obtenue par augmentation de la température du film de catalyseur.

Selon une variante, l'augmentation de température du film de catalyseur est globale, par exemple par recuit.

Selon une autre variante, l'augmentation de la température du film de catalyseur est localisée en surface, par exemple par irradiation laser ou par effet plasma.

Avantageusement, la couche de surface est en un matériau favorisant la fragmentation du film de catalyseur.

Selon une autre variante, la fragmentation du film de catalyseur sur la couche de surface est obtenue par des techniques de gravure inhomogène sèche ou humide du film de catalyseur. En d'autres termes, on grave uniquement certains endroits, par exemple au niveau des joints de grains.

Selon une première variante, le motif de la couche de catalyseur structurée est ajusté avant d'effectuer l'étape de gravure de la couche de surface. Avantageusement, le motif de la couche de catalyseur est ajusté par gravure de la couche de catalyseur.

Selon une deuxième variante, le motif de la couche de catalyseur est ajusté par gravure de ladite couche de catalyseur après avoir effectué l'étape de gravure de la couche de surface. Cela permet d'ajuster la morphologie des nanostructures.

Selon une troisième variante, le motif de la couche de catalyseur est ajusté, dans un premier temps, par gravure de ladite couche de catalyseur avant d'effectuer l'étape de gravure de la couche de surface et dans un deuxième temps, par gravure de ladite couche de catalyseur après avoir effectué la gravure de la couche de surface.

Avantageusement, la croissance sélective des nanostructures sur le catalyseur est réalisée par dépôt chimique en phase vapeur (CVD), assisté ou non par plasma.

En variante, l'étape de gravure de la couche de surface est effectuée après l'étape de croissance sélective des nanostructures.

Avantageusement, la couche de surface est une couche barrière à la diffusion du catalyseur vers le support.

L'invention concerne également une structure de cathode selon la revendication 17. Selon un premier exemple, la couche conductrice formant cathode est disposée au fond d'au moins un trou réalisé dans une couche en matériau électriquement isolant ; la couche conductrice formant cathode supporte la couche résistive, elle-même supportant la zone émettrice d'électrons comprenant les nanostructures, et la face supérieure de ladite couche en matériau électriquement isolant supporte la couche métallique formant grille d'extraction.

Selon un deuxième exemple, la couche conductrice formant cathode et la zone émettrice d'électrons comprenant des nanostructures sont disposées latéralement l'une par rapport à l'autre et séparées par la couche résistive ; la couche métallique formant grille d'extraction est séparée de la couche conductrice formant cathode par une couche d'isolant électrique. La couche résistive, qui est interposée entre la couche conductrice formant cathode et la zone émettrice, permet de les relier électriquement.

Selon un troisième exemple, une couche en matériau électriquement isolant supporte sur sa face inférieure la couche métallique formant grille d'extraction divisée en deux parties et encadrant la couche de matériau conducteur formant cathode disposée sur la face supérieure de la couche en matériau électriquement isolant, ladite couche conductrice formant cathode supportant une couche résistive, elle-même supportant la zone émettrice d'électrons.

L'invention concerne également un écran plat à émission de champ selon la revendication 21.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1, déjà décrite, est une vue en coupe transversale d'une structure de cathode à couche émissive, de type triode de type I selon l'art connu,
- la figure 2, déjà décrite, est une vue en coupe transversale d'une structure de cathode à couche émissive, de type triode de type II selon l'art connu,
- la figure 3 est une vue en coupe transversale d'un autre exemple de structure de cathode à couche émissive, de type I, selon l'art connu,
- la figure 4 est une vue de dessus de la structure de cathode à couche émissive, de type I, représentée à la figure 3,
- les figures 5a à 5d illustrent les étapes du procédé de réalisation de nanostructures selon la présente invention,
- la figure 6 est une représentation schématique selon une vue en coupe transversale d'un exemple de réalisation selon l'invention dans lequel les nanostructures sont électriquement indépendantes,
- la figure 7 est une représentation schématique selon une vue en coupe transversale d'un autre exemple de réalisation selon l'invention dans lequel les nanostructures sont électriquement indépendantes,
- la figure 8 est une représentation schématique selon une vue en coupe transversale de nanostructures sur des plots de couche barrière selon l'art antérieur,
- les figures 9a et 9b illustrent des étapes de réalisation de nanostructures électriquement indépendantes dans une structure de cathode selon l'invention,
- la figure 10 est une vue en coupe transversale d'une structure de cathode selon l'invention,
- la figure 11 est une vue en coupe transversale d'une autre structure de cathode selon l'invention,
- la figure 12 est une vue de dessus d'une structure de cathode à couche émissive, de type I, selon l'art antérieur,
- la figure 13 est une vue de dessus d'une structure de cathode à couche émissive, de type I, selon l'invention,
- les figures 14A à 14K illustrent un procédé de réalisation d'une structure de cathode de type triode selon l'invention,
- les figures 15a et 15b représentent des nanotubes jouant le rôle de canal conducteur ou semi-conducteur entre deux électrodes selon l'art antérieur et selon l'invention, respectivement.

Il est à noter que, pour simplifier, les différents éléments représentés dans ces figures ne sont pas dessinés à l'échelle.

### EXPOSÉ DÉTAILLÉ DE MODES DE RÉALISATION PARTICULIERS

Nous allons à présent détailler un exemple d'un mode de réalisation de nanostructures électriquement indépendantes sur un support selon l'invention.

Sur une face d'un support 100, par exemple un substrat en verre, on dépose une couche de surface 101. Avantageusement, cette couche est une couche barrière, c'est-à-dire en un matériau qui limite la diffusion du catalyseur vers le substrat (notamment à la température de croissance des nanostructures). On rappelle que, puisque l'on désire obtenir des nanostructures électriquement indépendantes et ayant une fonction de transport électrique, la couche barrière doit être électriquement conductrice car l'adressage électrique des nanostructures se fait par l'intermédiaire de leur support, soit ici la couche de surface. On peut choisir un matériau parmi TiN, TiW, TaN, Cr, Mo... pour réaliser cette couche de surface.

De plus, si l'on souhaite que la structuration de la couche de catalyseur soit obtenue par fragmentation par démouillage de la couche de catalyseur, il est préférable que la couche de surface soit en un matériau favorisant le démouillage.

Dans cet exemple, on choisit de déposer une couche de surface 101 en TiN d'une épaisseur de l'ordre de 100 nm.

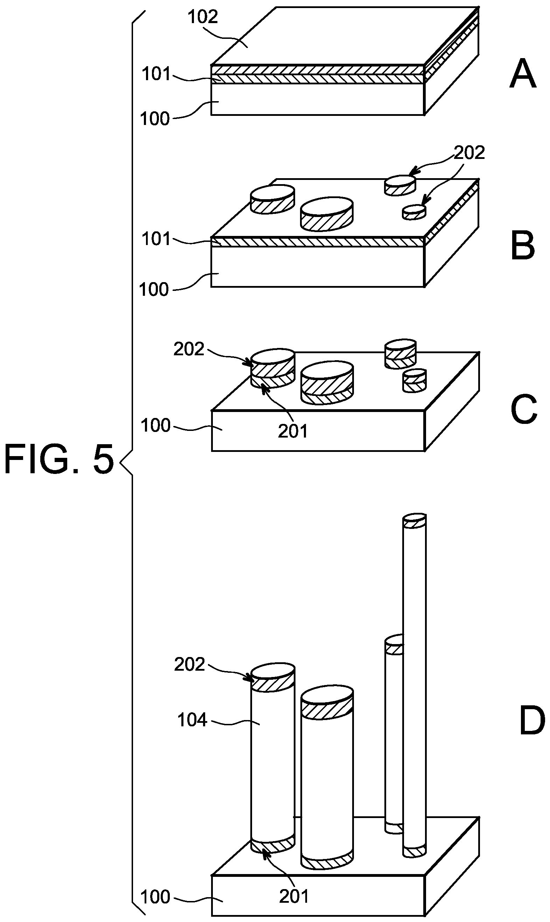

Puis, par-dessus cette couche de surface 101, on dépose une couche de catalyseur 102 en Ni d'une épaisseur par exemple de 10 nm. Si la fragmentation de cette couche de catalyseur doit être obtenue par démouillage, l'épaisseur de la couche de catalyseur doit être inférieure à un seuil donné, connu de l'homme du métier, fonction des matériaux utilisés et étudié par exemple dans le document **[5].** Typiquement, pour obtenir un démouillage de Ni sur TiN à 600°C, il faut que l'épaisseur de Ni soit inférieure ou égale à 10 nm. On obtient alors un empilement constitué du substrat support 100 supportant une couche de surface 101 et une couche de catalyseur 102 comme illustré dans la figure 5a. On aurait également pu choisir une couche de surface 101 en TaN et une couche de catalyseur 102 en un matériau choisi parmi le groupe comprenant Fe, Co, Ni, Pt ou tout alliage incluant l'un de ces matériaux. Les dépôts de la couche 101 de TiN et de la couche 102 de Ni peuvent par exemple être obtenu respectivement par pulvérisation cathode et évaporation sous vide.

Puis, on réalise la structuration de la couche de catalyseur 102 afin qu'elle présente un motif comprenant des zones pleines dans lesquelles le catalyseur est présent et des zones dans lesquelles le catalyseur a disparu pour mettre à jour la couche de surface 101 sous-jacente (figure 5b). Les zones pleines forment ce qu'on appelle des zones de croissance où les nanostructures vont venir croître.

Cette structuration peut se faire par fragmentation de la couche de catalyseur sur la couche de surface. La fragmentation peut être obtenue par augmentation de température globale de l'empilement (par exemple par recuit) ou localisée en surface (par exemple par irradiation laser ou à l'aide d'un plasma). Il faut noter que la fragmentation n'aura lieu qu'à condition que le couple (couche barrière - catalyseur) soit tel que la différence d'énergie de surface des deux matériaux soit suffisante pour permettre une fragmentation par démouillage. Pour le couple de matériaux TiN-Ni, un recuit à 600°C sous une pression de 0,2 mbar d'hydrogène convient pour une couche de Ni de 10 nm.

La fragmentation peut aussi être obtenue par des techniques de gravure inhomogène sèche (par plasma par exemple) ou humide de la couche de catalyseur 102. Ainsi, une gravure par plasma DC de NH₃ à 390°C peut fragmenter un film de Ni (voir par exemple les documents **[6]** et **[7]** cités à la fin de la description).

Selon une variante, la couche de catalyseur 102 peut être initialement discontinue ou structurée. Parmi les techniques connues pour déposer la couche de catalyseur directement sous forme structurée, on peut citer les dépôts électrochimiques (voir le document **[8]),** ou les dépôt d'agrégats ou encore la croissance discontinue, mode Volmer-Weber, qui correspond à un démouillage instantané à température ambiante pour des épaisseurs déposées très fines. Dans ce cas, on peut réaliser une étape supplémentaire pour affiner le motif qui va servir à la gravure de la couche de surface, par exemple par gravure ou recuit. Mais cette étape supplémentaire peut être superflue si le motif obtenu après dépôt est déjà adéquat.

Une fois que la couche de catalyseur 102 est structurée selon un motif adéquat, on réalise une gravure sélective et anisotrope de la couche de surface 101 en utilisant le catalyseur comme masque de gravure : la couche de surface 101 est gravée dans les zones non couvertes par la couche de catalyseur 102. On entend par motif adéquat un motif dans lequel les zones de croissance des nanostructures sont disposées aux endroits où l'on veut que les nanostructures croissent, mais surtout ont des dimensions et une densité adaptées au type de nanostructures que l'on veut faire croître. En général, le motif représentera des îlots de catalyseur, c'est-à-dire des tas de forme ovoïde, dispatchés sur la couche barrière de manière aléatoire de manière à obtenir des nanostructures de base elliptique.

On poursuit la gravure jusqu'à ce que la couche de surface 101 disparaisse dans les zones non couvertes par le catalyseur 102. Le substrat support comporte alors des îlots de catalyseur 202 sur des îlots de couche de surface 201 (figure 5c).

Pour le couple de matériaux TiN-Ni, la gravure anisotrope et sélective peut être obtenue en utilisant un plasma RIE de SF₆ : la couche de surface 101 de TiN est gravée de façon directive (gravure anisotrope) et les îlots de catalyseur 202 de Ni ne sont pas gravés (gravure sélective), ainsi que les îlots de couche de surface 201 (couche de surface de TiN recouverte par le catalyseur Ni).

Selon une variante, on peut ajuster la densité et la distribution de taille des îlots de catalyseur 202, obtenus après l'étape de structuration, au moyen d'une gravure sèche ou humide d'une partie du catalyseur. On peut ainsi obtenir des îlots de catalyseur de diamètre et de densité déterminés. Cet ajustement par gravure peut être réalisé entre les étapes de structuration et de gravure de la couche de surface 101, et/ou entre les étapes de gravure de la couche de surface 101 et de croissance sélective des nanostructures. Dans ce dernier cas, on obtient des plots de catalyseur plus petits que les plots de la couche de surface sur laquelle il repose, ce qui peut assurer dans certains cas une plus grande stabilité de la nanostructure.

Par exemple, si on choisit de réaliser une gravure humide du catalyseur, on peut plonger l'échantillon dans une solution d'attaque chimique du catalyseur pendant une durée déterminée. Dans ce cas, on utilise de préférence une solution qui attaque sélectivement le catalyseur et qui n'empêche pas le catalyseur de réagir avec les précurseurs (gazeux dans le cas d'une croissance par CVD) des nanostructures dont il devra par la suite catalyser la croissance. Par exemple, on peut utiliser une solution réalisée en mélangeant un volume d'acide nitrique, un volume d'acide acétique et quatre volumes d'eau pour réaliser l'attaque chimique du catalyseur pendant une durée de 45 secondes.

Si on choisit de réaliser une gravure sèche du catalyseur, on peut réaliser une gravure par plasma (RIE, ICP...) ou par bombardement ionique sélectif du catalyseur.

L'ajustement de la densité et de la distribution de taille des îlots de catalyseur 202 peut également être obtenu par contrôle de l'épaisseur initiale de la couche de catalyseur 102 dans le cas où le motif de catalyseur est obtenu par fragmentation par démouillage d'une couche de catalyseur initialement continue.

Enfin, on effectue une croissance catalytique de nanostructures 104 à partir des îlots de catalyseurs 202. Cette croissance peut être du type « croissance par la base » (en anglais « base growth » ou « root growth »), où les nanostructures sont obtenues par croissance catalytique avec le catalyseur ancré sur le support, ou du type « croissance par le sommet » (« tip growth » en anglais), où les nanostructures 104 sont obtenues par croissance catalytique avec le catalyseur 202 se retrouvant au sommet des nanostructures (figure 5d).

Pour obtenir des nanotubes 104 de carbone à partir d'îlots de catalyseur 202 en nickel, on peut réaliser une croissance catalytique par dépôt chimique en phase vapeur (CVD) de carbone en augmentant la température jusqu'à 600°C sous 0,2 mbar d'hydrogène, puis en exposant l'échantillon à une pression de 0,2 mbar d'acétylène, toujours à 600°C, pendant 1 minute. On obtient ainsi des nanotubes 104 de carbone sur chaque îlot de couche de surface 201 en TiN, avec un îlot de catalyseur 202 de Ni à leur sommet (croissance du type « croissance par le sommet »). Les nanotubes ont une longueur pouvant atteindre plusieurs micromètres et un rayon voisin de celui de l'îlot de catalyseur. La croissance CVD présente la particularité de donner lieu à une population de nanotubes dont le rapport d'aspect (longueur/rayon) est très dispersé comme illustré dans la figure 5d où l'on peut voir des nanotubes 104 de hauteur et de diamètre variés.

Selon une variante, l'étape de gravure de la couche de surface 101 peut avoir lieu après l'étape de croissance des nanostructures 104, à condition que la gravure soit sélective vis à vis des nanostructures et que la forme des nanotubes le permette (en particulier, il est préférable que les nanostructures soient alignées perpendiculairement au support).

L'invention présente un procédé permettant d'obtenir des nanostructures, et notamment des nanostructures électriquement indépendantes. Par « nanostructure », on entend toute structure auto-assemblée et localisée par croissance catalytique sur un catalyseur supporté et dont l'une des dimensions est nanométrique, c'est-à-dire comprise entre 0,5 et 100 nm. Par « nanostructures électriquement indépendantes », on entend des nanostructures dont le potentiel électrique est différent pour chaque nanostructure. Par opposition, des nanostructures sont non électriquement indépendantes lorsque leur potentiel électrique est le même, ce qui est le cas, par exemple, lorsqu'elles reposent sur un support conducteur et sont liées entre elles électriquement par ce support. On rappelle par ailleurs que les nanostructures peuvent être des nanotubes ou des nanofilaments ou des nanofils par exemple, en général un par nanostructure. Mais il peut y avoir plusieurs nanotubes ou nanofilaments ou nanofils par nanostructure si ces éléments croissent à partir du même îlot de catalyseur et/ou sur le même îlot de couche de surface.

Nous venons de détailler un exemple de formation de nanostructures à partir d'un empilement constitué simplement d'un support, d'une couche barrière et d'une couche de catalyseur. D'autres exemples de réalisation sont possibles, notamment en utilisant un empilement beaucoup plus complexe. Par exemple, on peut réaliser les mêmes étapes que précédemment en interposant une couche résistive, ou une couche conductrice surmontée d'une couche résistive, entre le substrat support et la couche barrière. Il est également possible d'utiliser un multicouche à la place de la couche de catalyseur, par exemple un bicouche constitué de Fe et Mo, pour favoriser la croissance des nanostructures.

Selon un exemple particulier, on réalise un empilement comprenant un substrat support en verre, une couche conductrice 403 en Mo formant cathode et une couche résistive 406 en Si pour servir de couche résistive (ou ballast), une couche barrière 401 et une couche de catalyseur 402. Puis, on réalise les mêmes étapes que celles décrites plus haut dans les figures 5a à 5d, c'est-à-dire l'étape de structuration du catalyseur 402, l'étape de gravure de la couche barrière 401 et l'étape de croissance des nanostructures 404 sur les îlots de catalyseur. Toutes les variantes décrites plus haut peuvent également s'appliquer, notamment la possibilité d'ajuster la densité et la distribution de taille des îlots de catalyseur, obtenus après l'étape de structuration, au moyen d'une gravure sèche ou humide entre les étapes de structuration et de gravure de la couche barrière, et/ou entre les étapes de gravure de la couche barrière et de croissance sélective des nanostructures.

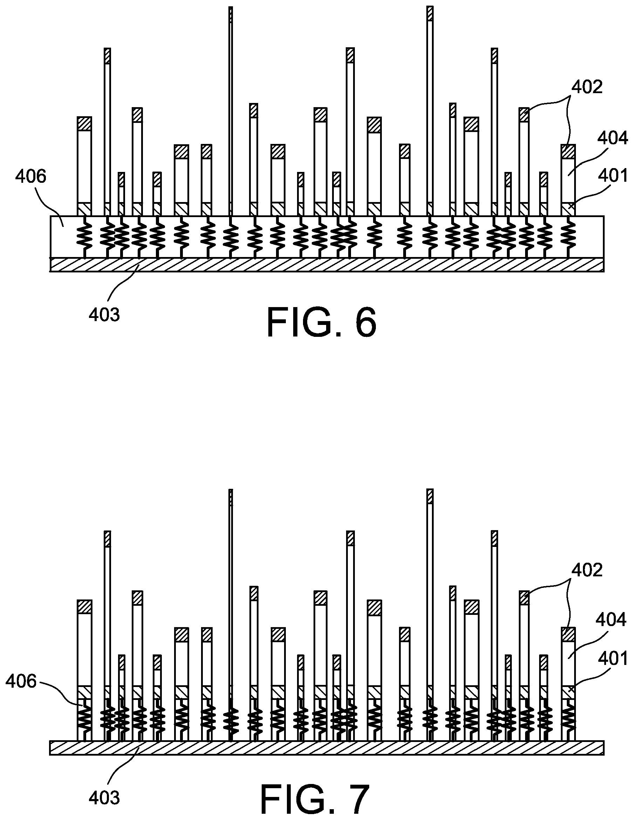

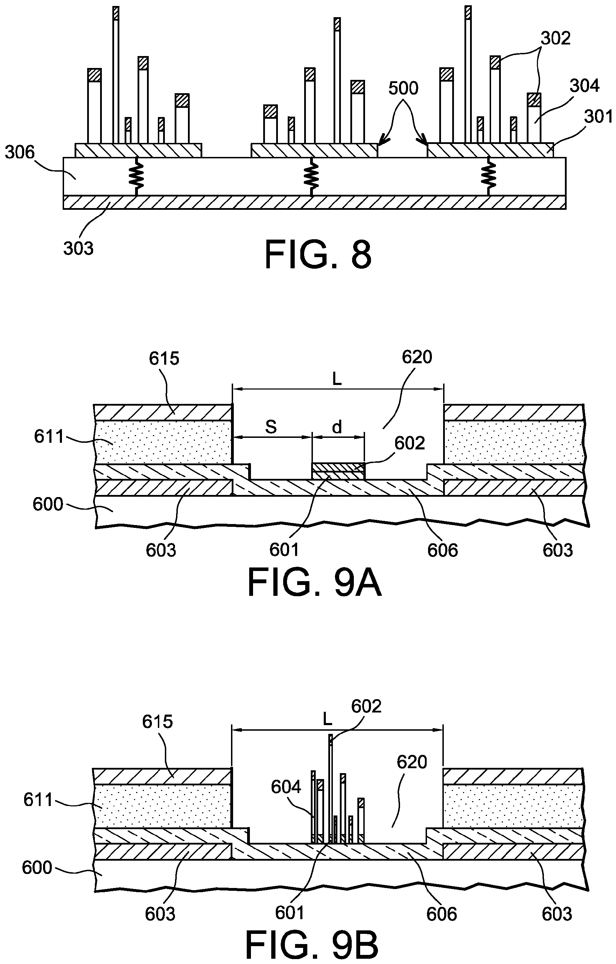

La figure 6 représente le cas où la gravure de la couche barrière 401 a été arrêtée au niveau de la couche résistive 406. Mais l'arrêt de la gravure sur la couche résistive n'est pas critique dans ce cas particulier. En effet, comme la couche résistive 406 est sur une couche de cathode 403, on peut se permettre de graver la totalité ou une partie de cette couche résistive, ce qui favorise encore l'indépendance électrique des nanostructures. La figure 7 illustre le cas où toute l'épaisseur de la couche résistive 406 ainsi que l'épaisseur de la couche barrière 401 ont été gravées dans les zones non couvertes par le catalyseur. Cette gravure de la couche résistive peut se faire en même temps que la gravure de la couche barrière si la technique de gravure utilisée pour la couche barrière convient pour la couche résistive, ou juste après avec une autre technique de gravure, ou encore après la croissance des nanostructures si les nanostructures le permettent (comme expliqué précédemment). Dans les exemples illustrés dans les figures 6 et 7, on obtient bien au final des nanotubes électriquement indépendants, contrairement à l'art antérieur illustré dans la figure 8, où seuls des groupes de nanotubes 304 peuvent être indépendants électriquement. Les nanotubes 304, réalisés par croissance catalytique à partir de catalyseur 302, sont disposés sur des blocs 500 réalisés dans une couche barrière 301, disposée sur une couche résistive 306 supportée par une couche conductrice 303. Chaque bloc 500 est isolé des autres blocs mais chaque bloc supporte plusieurs nanostructures 304. Ainsi, le potentiel électrique à la base de chaque nanostructure d'un même bloc est le même. L'invention permet ainsi d'assurer l'indépendance électriques des nanostructures les unes par rapport aux autres et une action individualisée de la couche résistive (illustrée par le symbole en zigzag symbolisant une résistance dans les figures 6 et 7) pour chaque nanostructure, ce qui améliore l'uniformité de l'émission des électrons.

Cet empilement particulier d'un substrat support, d'une couche conductrice formant cathode, d'une couche résistive formant un ballast, d'une couche barrière et d'une couche de catalyseur permet de réaliser une structure cathodique pour un écran plat à émission de champ. Nous allons présenter plusieurs exemples de structures de cathode présentant des nanostructures électriquement indépendantes et pouvant être utilisées dans un écran plat à émission de champ.

Un premier exemple d'une structure de cathode selon l'invention est illustré dans la figure 9b. Il s'agit d'une structure triode de type I vue en coupe transversale. Selon la figure 9a, on peut voir que cette structure de cathode comprend, en superposition sur un support 600, une électrode de cathode 603 en deux parties dans un matériau conducteur, une couche résistive 606 recouvrant les deux parties de l'électrode de cathode 603 et la surface du support 600 située entre ces deux parties, une couche isolante 611 et une couche métallique 615 formant grille d'extraction des électrons. Un trou 620 de largeur L expose la couche résistive 606. Au centre du trou 620 et à une distance S de la couche de cathode 603, un empilement d'une largeur d constitué d'une couche barrière 601 et d'une couche de catalyseur 602 repose sur la couche résistive 606. La distance S est choisie pour avoir une longueur efficace de la couche résistive de l'ordre de S (et non de l'ordre de l'épaisseur de cette couche comme dans le cas S=0 (couche résistive sur couche cathode)), ce qui permet d'obtenir une résistance plus élevée à épaisseur et résistivité identiques de la couche résistive, et donc améliorer l'uniformité de l'émission. De préférence, la largeur d de l'empilement constitué par la couche barrière 601 et la couche de catalyseur 602 est faible par rapport à la largeur L du trou. Cela permet de limiter les possibilités de contact des nanostructures avec l'électrode de grille, source de courant de fuite entre cathode et grille en fonctionnement. Ici, les parties de l'électrode de cathode 603 sont situées à l'aplomb de la grille d'extraction 605. Elles pourraient également être en retrait par rapport à l'aplomb de la grille 605. Le détail d'un procédé de réalisation de cette structure peut être trouvé dans le document **[4].**

On réalise ensuite la structuration de la couche de catalyseur 602, la gravure de la couche barrière 601 et la croissance des nanostructures 604 selon le procédé de réalisation décrit précédemment. On obtient alors des nanostructures 604 électriquement indépendantes comportant une base faite d'une couche barrière 601 et un sommet fait de catalyseur 602 selon une croissance catalytique de type « croissance par le sommet » (voir figure 9b). Dans cet exemple particulier, les nanostructures 604 sont reliées électriquement aux parties de l'électrode de cathode 603 par l'intermédiaire de la couche résistive 606. On notera qu'un seul dispositif d'émission est représenté sur cette figure, mais la structure de cathode peut en comprendre plusieurs autres.

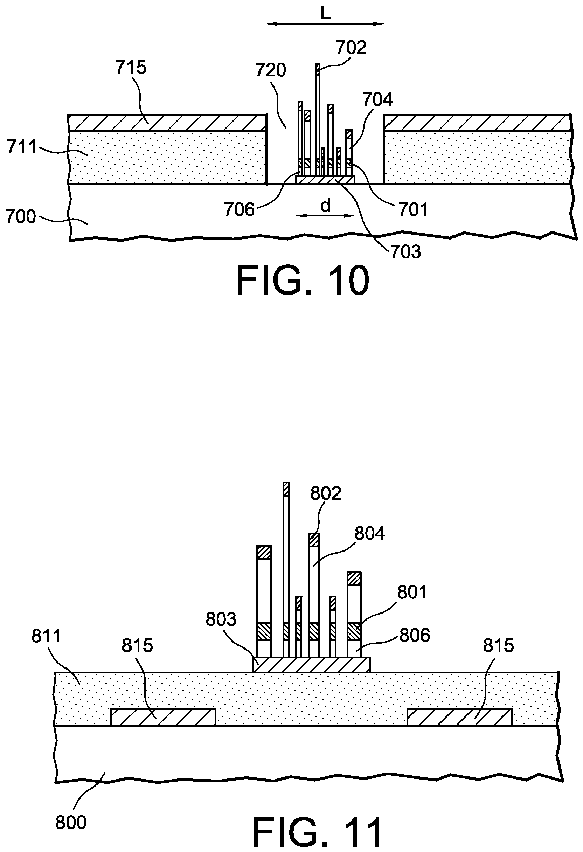

Un deuxième exemple d'une structure de cathode de type I est illustré dans la figure 10. Un support 700 supporte une couche 711 en matériau électriquement isolant. La couche 711 est percée d'un trou 720 et la face supérieure de la couche d'isolant 711 supporte une couche métallique 715 formant grille d'extraction et entourant le trou 720. Au fond du trou 720 de largeur L, un empilement de largueur d est constitué d'une couche conductrice 703 formant cathode supportant des nanostructures 704 électriquement indépendantes. De même que dans l'exemple précédent, la largeur d de l'empilement est de préférence faible par rapport à la largeur L du trou.

Ces nanostructures 704 ont été obtenues par réalisation des étapes de procédé selon l'invention à partir d'un empilement initial composé d'une couche résistive 706, d'une couche barrière 701 et d'une couche de catalyseur 702. On voit dans cet exemple que toute l'épaisseur de la couche résistive 706 a été gravée, comme expliqué dans la figure 7.

Enfin, la figure 11 représente, vue en coupe et de façon schématique, une structure de cathode de type II selon l'invention. Une couche 811 en matériau électriquement isolant supporte sur sa face inférieure une électrode de grille 815 constituée de deux parties encadrant une cathode 803 disposée sur la face supérieure de la couche 811 et supportant des nanostructures 804 électriquement indépendantes. Ces nanostructures 804 ont été obtenues par réalisation des étapes de procédé selon l'invention à partir d'un empilement initial composé d'une couche résistive 806, d'une couche barrière 801 et d'une couche de catalyseur 802. Dans cet exemple, toute l'épaisseur de la couche résistive 806 a été gravée, comme expliqué dans la figure 7.

Il est à noter que certaines contraintes peuvent apparaître pour l'étape de gravure de la couche barrière dans des cas précis de réalisation de structure de cathode.

Une première contrainte de réalisation à prendre en compte apparaît lorsque le conducteur de grille des structures de cathode n'est pas protégé, comme c'est le cas dans les figures 9a et 9b, et 10 (conducteur de grille 615 ou 715). Il est nécessaire de choisir un matériau pour l'électrode de grille qui ne soit pas sensible à la gravure choisie pour la couche barrière. Par exemple, si on utilise un plasma RIE de SF₆ pour graver la couche barrière, une électrode de grille en cuivre ou en aluminium ne sera pas attaquée par le plasma.

Une autre contrainte consiste à ne pas graver la couche résistive sur toute son épaisseur lorsque la cathode est disposée latéralement par rapport aux nanostructures, comme c'est le cas dans la figure 9b. Si toute l'épaisseur de la couche résistive 606 est gravée, alors les nanostructures seraient électriquement isolées de la cathode. On rappelle en effet que c'est la couche résistive 606 qui relie ici électriquement les nanostructures 604 aux parties de l'électrode de cathode 603. Au contraire, lorsque la cathode est disposée à l'aplomb des nanostructures émettrices d'électrons (voir par exemple la figure 10 ou la figure 11), on peut graver toute l'épaisseur de la couche résistive (à condition toutefois que la gravure épargne les électrodes situées dessous, telles que la cathode et éventuellement la grille enterrée). Une telle gravure peut présenter l'avantage d'améliorer l'isolement entre la cathode et le conducteur de grille. Pour une gravure RIE de SF₆, on pourra par exemple choisir des électrodes en cuivre ou aluminium.

Chacune des structures de cathode décrites plus haut peuvent être utilisées pour réaliser un écran plat à émission de champ. Pour cela, on place la structure cathodique en regard d'une anode recouverte d'une couche luminescente, et l'espace séparant l'anode et la structure cathodique est mis sous vide.

En général, pour la fabrication d'écrans plats à émission de champ, on utilise de préférence des nanostructures (nanotubes ou nanofilaments) de carbone comme émetteurs d'électron. En effet, les nanostructures en carbone présentent plusieurs avantages.

Tout d'abord, les nanostructures de carbone présentent un rapport d'aspect (longueur/rayon) important qui permet d'amplifier le champ électrique par effet de pointe au sommet des nanostructures. On peut ainsi réaliser l'extraction d'électrons par effet de champ pour des champs électriques appliqués relativement faibles.

Par ailleurs, les nanostructures de carbone ont une conductivité électrique et thermique compatible avec une utilisation comme électrode et elles présentent une inertie chimique, ce qui garantit une bonne stabilité de leurs propriétés dans le temps.

Enfin, les nanostructures de carbone peuvent être synthétisées in situ de façon localisée, sur de grandes surfaces et à relativement bas coût.

En revanche, les nanostructures de carbone ont l'inconvénient de présenter une forte distribution des rapports d'aspect, ce qui se traduit par une forte distribution du champ électrique à leur sommet pour un champ électrique appliqué donné. Or, le courant électrique extrait par émission de champ dépend de façon exponentielle du champ électrique au sommet des émetteurs. Il est donc important de minimiser cette distribution si l'on veut uniformiser le courant électrique issu de chaque émetteur et obtenir une brillance uniforme sur l'écran, ce qui se traduit par une qualité visuelle accrue pour l'écran.

Dans l'art antérieur, une solution bas coût consistait à disposer une couche résistive sous la couche barrière et de regrouper les nanotubes sur des plots de couches barrière électriquement isolés les uns des autres (voir figure 8). Cependant, le problème n'était pas résolu au sein d'un groupe de nanotubes sur un même plot. La présente invention permet de résoudre cette limitation puisqu'on obtient des nanostructures individuellement bridées par la couche résistive : le potentiel électrique à la base de chaque nanostructures émettrices d'électrons est différent pour chacune, proportionnel au courant qui la traverse (voir figures 6 et 7). L'invention permet donc d'augmenter le nombre de nanostructures émettrices en mesure de fonctionner dans les mêmes conditions de champ appliqué. Idéalement, toutes les nanostructures émettrices peuvent fonctionner ensemble (contre 1/10⁴ dans l'état actuel de l'art).

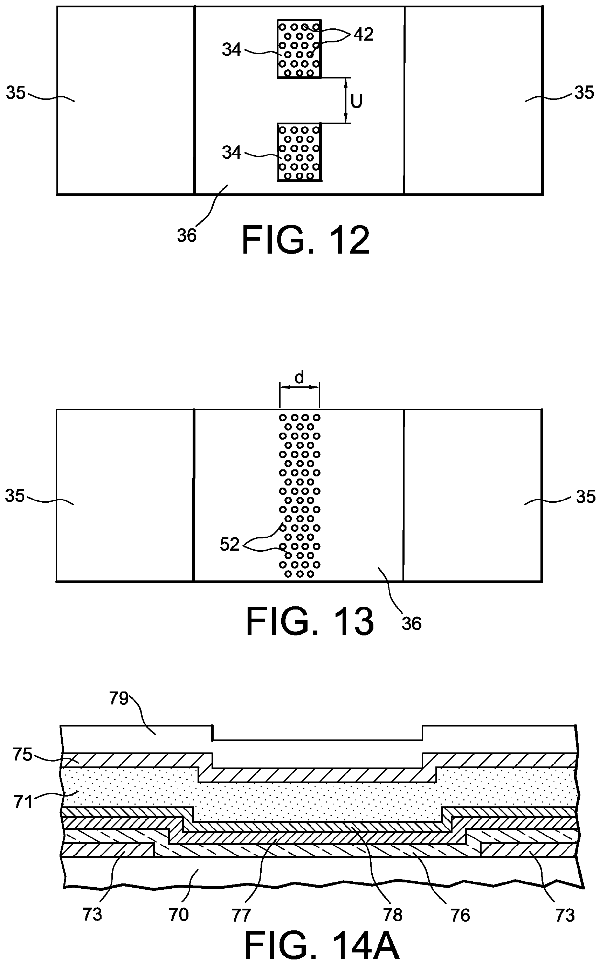

On remarquera qu'avec le procédé selon l'invention, il n'est plus nécessaire de structurer la couche barrière sous forme de plots isolés les uns des autres tel que décrit dans le document **[4]** et illustré dans la figure 4 décrite précédemment. En effet, on peut déposer une bande continue de couche barrière puisque la couche barrière est ensuite gravée dans les zones non couvertes par le catalyseur. Contrairement à l'art antérieur où les nanostructures 42 situées sur un même plot 34 sont électriquement dépendantes (voir la figure 12), les nanostructures 52 selon notre invention peuvent être continûment réparties selon une bande de largeur d et être quand même électriquement indépendantes (voir la figure 13). Ainsi on augmente la surface émissive du dispositif final par rapport à l'art antérieur, tout en garantissant l'indépendance électrique des nanostructures et par là même, l'homogénéité de leur émission.

On peut ainsi envisager un nouveau procédé de réalisation d'une structure triode de type I. Les figures 14A à 14K illustrent les étapes de ce procédé qui met en oeuvre des techniques de dépôt sous vide et de photolithographie.

Tout d'abord, selon la figure 14A, on fournit un empilement comprenant, en superposition sur un support 70, une électrode de cathode 73 en deux parties, une couche résistive 76 recouvrant les deux parties de l'électrode de cathode 73, une couche barrière 77, une couche de catalyseur 78, une couche d'isolant 71, une couche métallique 75 destinée à former une grille d'extraction d'électrons, et une couche de résine 79 photosensible.

L'électrode de cathode 73 est obtenue par dépôt d'un matériau conducteur, par exemple le molybdène, le niobium, le cuivre ou l'ITO, sur un support 70, par exemple en verre. Le dépôt de matériau conducteur est ensuite gravé en bandes, typiquement de 10 µm de largeur et de pas égal à 25 µm. C'est en associant deux bandes qu'on forme une électrode de cathode 73.

Les autres couches sont obtenues par dépôts sous vide selon l'ordre suivant : une couche résistive 76 de 1,5 µm d'épaisseur en silicium amorphe, une couche barrière 77 de TiN d'environ 100 nm et une couche de catalyseur 78 en Ni d'environ 10 nm, puis une couche isolante 71 de 1 µm d'épaisseur en silice ou en nitrure de silicium, une couche métallique 75 en aluminium destinée à former la grille d'extraction des électrons et enfin une couche de résine 79 photosensible.

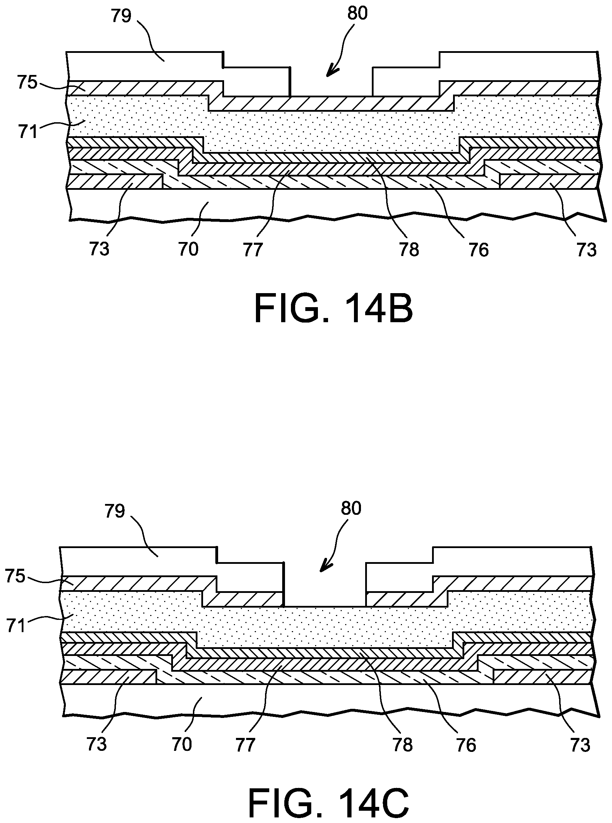

Puis, on effectue une photolithographie de la couche de résine (voir figure 14B). On grave l'épaisseur de la résine photosensible pour obtenir une ouverture 80 d'environ 6 µm et exposer la couche métallique 75 de grille sous-jacente.

On réalise ensuite une gravure chimique de la couche de grille 75 en aluminium avec un mélange comprenant de l'acide acétique, de l'acide nitrique et de l'acide orthophosphorique en utilisant la résine 79 comme masque de gravure (voir figure 14C).

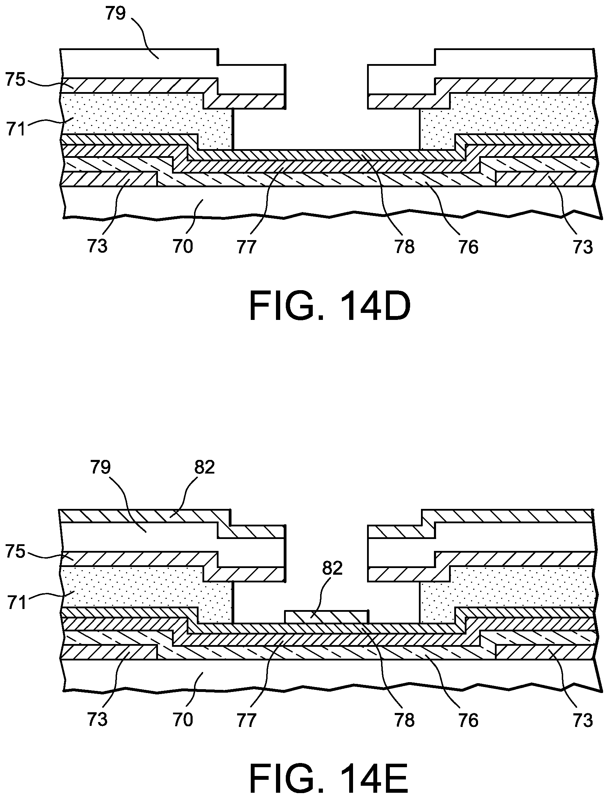

Puis, on réalise l'ouverture de gorges dans l'épaisseur de la couche de silice 71 en introduisant du HF par l'ouverture réalisée à l'étape précédente dans la couche de grille (figure 14D). Cette gravure humide par HF entraîne une gravure « sous » la couche de grille créant ainsi un surplomb au niveau de la grille.

On dépose ensuite par évaporation une couche protectrice 82 de chrome au fond de l'ouverture, ainsi que sur la couche de résine photosensible (figure 14E) .

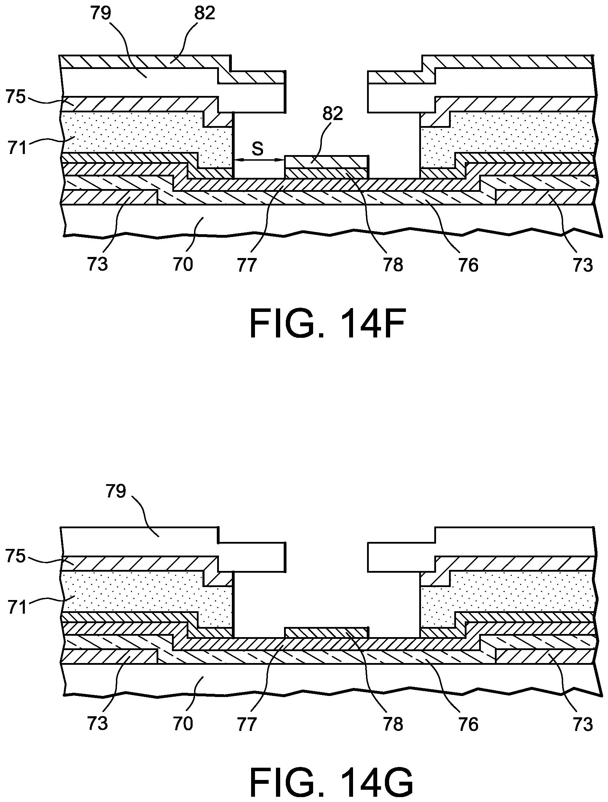

Selon la figure 14F, la couche de catalyseur non protégée par la couche de chrome 82 est gravée en utilisant par exemple de l'acide orthophosphorique. La couche de grille en aluminium non recouverte par la couche de silice (partie en surplomb) est également gravée en même temps afin de ménager l'espace S (décrit plus haut) entre la grille et la future zone émettrice d'électrons, et ainsi éviter les courts-circuits.

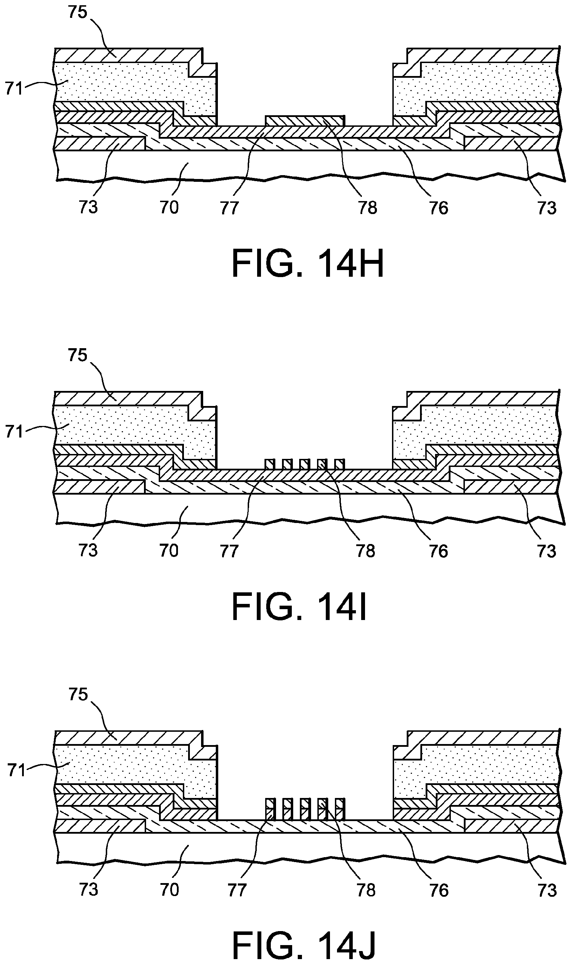

Puis on élimine la couche protectrice en la gravant à l'aide d'un mélange commercial d'acide perchlorique et de nitrate d'ammonium cérium (figure 14G) et on élimine la résine photosensible par technique de « lift off » (figure 14H).

On réalise la fragmentation de la couche de catalyseur jusqu'à obtenir des îlots de catalyseur (figure 14I) et on grave la couche barrière non protégée par le catalyseur, par exemple par plasma RIE de SF₆ (figure 14J).

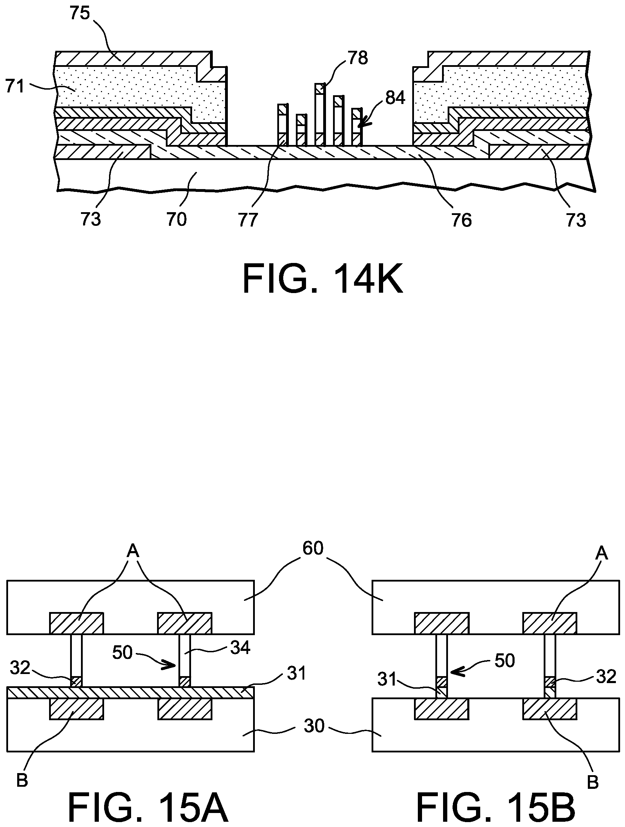

Enfin, on fait croître des nanostructures 84 sur les îlots de catalyseur (figure 14K).

L'intérêt de ce procédé est qu'il permet de minimiser le nombre d'alignement de masques lithographiés : on utilise uniquement un masque pour graver l'électrode de cathode et un masque pour graver la résine.

Le besoin d'obtenir des nanostructures électriquement indépendantes peut apparaître dans tout autre domaine où les nanotubes ont une fonction électrique et qu'ils reposent sur une couche conductrice. Par exemple, les nanostructures électriquement indépendantes peuvent servir de canal conducteur ou semi-conducteur entre deux électrodes. Par exemple, un nanotube de carbone peut servir de canal conducteur et connecter deux niveaux de métallisation différents dans une puce. Ce nanotube de carbone devrait pouvoir supporter une densité de courant 1000 fois supérieure à un canal conducteur en cuivre, qui est soumis aux ruptures induites par électromigration (voir document **[9]).**

On peut également réaliser des nanotubes servant de canal semi-conducteur pour obtenir un transistor vertical à grille coaxiale (en anglais « vertical coaxially gated CNT transistor ») (voir documents **[9]** et **[10]).**

Dans l'art antérieur, le canal conducteur 50 en nanotube de carbone permettant de relier les électrodes B d'un premier support 30 (par exemple une puce) et un second support 60 en surplomb est en général réalisé par dépôt en couche pleine d'une couche barrière 31 conductrice sur le premier support 30 comprenant les électrodes B, puis par dépôt d'un plot de catalyseur 32 sur chaque zone surplombant les électrodes B, et par croissance CVD de nanotubes 34 de carbone jusqu'à relier les électrodes A du support supérieur 60 (voir figure 15a). Grâce à l'invention, chaque canal conducteur 50 est électriquement indépendant de ces voisins car la couche barrière 31 à la base de chaque nanotube 34 est gravée en utilisant le catalyseur 32 comme masque de gravure (figure 15b).

En résumé, le procédé selon l'invention présente l'avantage d'être facile à mettre en oeuvre, peu onéreux, auto aligné (c'est-à-dire sans nécessité d'alignement de masque de lithographie) et compatible avec une large gamme de dimensions des particules de catalyseur. La taille minimale des îlots de catalyseur utilisables selon l'invention est fixée par le degré d'anisotropie de la gravure, par son degré de sélectivité, et par l'épaisseur de la couche de surface à graver.

### BIBLIOGRAPHIE

**[1]** FR-A-2 593 953 (correspondant au brevet US N° 4 857 161).
**[2]** FR-A-2 798 507.
**[3]** FR-A-2 798 508 (correspondant au brevet US N° 6 815 902).
**[4]** EP 1 336 980 A1 (correspondant au brevet US 2003/0184357 A1).
**[5]** « The Thermodynamics and Kinetics of Film Agglomération », David J. Srolovitz et Max G. Goldiner, Journal of Metals (1995), 47(3), 31-36,76-77.
**[6]** « Control of carbon nanotubes density through Ni nanoparticle formation using thermal and NH3 plasma treatment », Jong Hyung Choi et al., Diamond and related materials (2003), 12, 794-798.
**[7]** «Density control of carbon nanotubes using NH3 plasma treatment of Ni catalyst layer », Jong Hyung Choi et al., Thin Solid Films (2003), 435, 318-323.
**[8]** « Growth of aligned carbon nanotubes with controlled site density », Y. Tu et al., Applied Physics Letters (2002), 80(21), 4018-4020.
**[9]** G.S. Duesberg et al./ Diamond and Related Materials 13 (2004) 354-361.
**[10]** A.P. Graham et al. / Diamond and Related Materials 13 (2004) 1296-1300.

## Revendications

1. Procédé de réalisation de nanostructures (104 ;404 ;604 ;704 ;804) sur un support, comprenant les étapes suivantes :
- fourniture d'un support comprenant, sur une de ses faces, une couche de surface (101 ;401 ;601 ;701 ; 801) ;
- recouvrement de la couche de surface par une couche de catalyseur (102 ;202 ;402 ;602 ;702 ;802) structurée selon un motif faisant apparaître des zones de la couche de surface couvertes par le catalyseur et des zones de la couche de surface non couvertes par le catalyseur, la couche de surface étant une couche barrière à la diffusion du catalyseur vers le support ;
- gravure de l'épaisseur de la couche de surface (101 ;401 ;601 ;701 ;801) dans toutes les zones non couvertes par la couche de catalyseur en utilisant la couche de catalyseur structurée comme masque de gravure, jusqu'à ce que la couche de surface disparaisse dans les zones non couvertes par la couche de catalyseur ;
- croissance sélective de nanostructures (104 ; 404 ;604 ;704 ;804) sur les zones de la couche de surface couvertes par le catalyseur.

2. Procédé de réalisation de nanostructures selon la revendication 1, **caractérisé en ce que** la couche de surface est en matériau conducteur ou semi-conducteur et les nanostructures sont en un matériau conducteur ou semi-conducteur.

3. Procédé de réalisation de nanostructures selon la revendication 1 ou 2, **caractérisé en ce que** le support comporte une couche résistive (406 ;606 ;706 ;806) sur la face destinée à supporter la couche de surface (401 ;601 ;701 ;801).

4. Procédé de réalisation de nanostructures selon la revendication 3, **caractérisé en ce que** le support comporte une couche de matériau conducteur (403) en contact avec la couche résistive.

5. Procédé de réalisation de nanostructures selon la revendication 3 ou 4, **caractérisé en ce qu'**au moins une partie de l'épaisseur de la couche résistive est gravée dans les zones où la couche de surface est gravée.

6. Procédé de réalisation de nanostructures selon l'une quelconque des revendications 1 à 5, **caractérisé en ce que** la structuration de la couche de catalyseur selon un motif est obtenue par fragmentation d'un film de catalyseur sur la couche de surface.

7. Procédé de réalisation de nanostructures selon la revendication 6, **caractérisé en ce que** la fragmentation du film de catalyseur sur la couche de surface est obtenue par augmentation de la température du film de catalyseur.

8. Procédé de réalisation de nanostructures selon la revendication 7, **caractérisé en ce que** l'augmentation de température du film de catalyseur est globale, par exemple par recuit.

9. Procédé de réalisation de nanostructures selon la revendication 7, **caractérisé en ce que** l'augmentation de la température du film de catalyseur est localisée en surface, par exemple par irradiation laser ou par effet plasma.

10. Procédé de réalisation de nanostructures selon l'une quelconque des revendications 6 à 9, **caractérisé en ce que** la couche de surface est en un matériau favorisant la fragmentation du film de catalyseur.

11. Procédé de réalisation de nanostructures selon la revendication 6, **caractérisé en ce que** la fragmentation du film de catalyseur sur la couche de surface est obtenue par des techniques de gravure inhomogène sèche ou humide du film de catalyseur.

12. Procédé de réalisation de nanostructures selon l'une quelconque des revendications 1 à 11, **caractérisé en ce que** le motif de la couche de catalyseur structurée est ajusté avant d'effectuer l'étape de gravure de la couche de surface.

13. Procédé de réalisation de nanostructures selon la revendication 12, **caractérisé en ce que** le motif de la couche de catalyseur est ajusté par gravure de la couche de catalyseur.

14. Procédé de réalisation de nanostructures selon l'une quelconque des revendications 1 à 13, **caractérisé en ce que** le motif de la couche de catalyseur est ajusté par gravure de ladite couche de catalyseur après avoir effectué l'étape de gravure de la couche de surface.

15. Procédé de réalisation de nanostructures selon l'une quelconque des revendications 1 à 14, **caractérisé en ce que** la croissance sélective des nanostructures sur le catalyseur est réalisée par dépôt chimique en phase vapeur (CVD).

16. Procédé de réalisation de nanostructures selon l'une quelconque des revendications 1 à 15, **caractérisé en ce que** l'étape de gravure de la couche de surface est effectuée après l'étape de croissance sélective des nanostructures.

17. Structure de cathode comprenant :
- un support (600 ; 700 ; 800) ;
- une couche conductrice formant cathode (603 ; 703 ; 803) sur le support ;
- au moins une zone émettrice d'électrons comprenant des nanostructures émettrices d'électrons (604 ; 704 ; 804) formées à partir d'une couche de catalyseur (602 ; 702 ; 802) recouvrant une couche barrière (601 ; 701 ; 801) à la diffusion du catalyseur, ladite couche barrière étant supportée par une couche résistive, les nanostructures étant électriquement connectées à la couche conductrice formant cathode par l'intermédiaire de la couche barrière et de la couche résistive ;
- une couche métallique formant grille d'extraction (615 ; 715 ; 815) pour extraire les électrons émis par les nanostructures ;
la structure de cathode étant **caractérisée en ce que** les nanostructures sont des nanostructures électriquement indépendantes obtenues en structurant la couche de catalyseur selon un motif comprenant des zones pleines, dans lesquelles le catalyseur est présent, séparées par des zones dans lesquelles le catalyseur n'est pas présent, les zones pleines de la couche de catalyseur formant des zones de croissance pour les nanostructures, la couche de barrière étant absente dans toutes les zones non couvertes par le catalyseur et étant gravée de manière à former des îlots séparés les uns des autres, chaque nanostructure ayant son propre îlot.

18. Structure de cathode selon la revendication 17, dans laquelle la couche conductrice formant cathode (703) est disposée au fond d'au moins un trou réalisé dans une couche en matériau électriquement isolant (711), la couche conductrice formant cathode supportant la couche résistive, elle-même supportant la zone émettrice d'électrons comprenant les nanostructures (704) et la face supérieure de la couche en matériau électriquement isolant (711) supportant la couche métallique formant grille d'extraction (715).

19. Structure de cathode selon la revendication 17, dans laquelle la couche conductrice formant cathode (603) et la zone émettrice d'électrons comprenant des nanostructures (604) sont disposées latéralement l'une par rapport à l'autre et séparées par la couche résistive (606), la couche métallique formant grille d'extraction (615) étant séparée de la couche conductrice formant cathode (603) par une couche d'isolant électrique (611).

20. Structure de cathode selon la revendication 17, dans laquelle une couche en matériau électriquement isolant (811) supporte sur sa face inférieure la couche métallique formant grille d'extraction (815) divisée en deux parties et encadrant la couche de matériau conducteur formant cathode (803) disposée sur la face supérieure de la couche en matériau électriquement isolant (811), la couche conductrice formant cathode (803) supportant la couche résistive, elle-même supportant la zone émettrice d'électrons.

21. Ecran plat à émission de champ comprenant une structure de cathode et une anode, recouverte d'une couche luminescente, l'anode étant disposée en regard de la structure de cathode, et l'anode et la structure de cathode étant séparées par un espace dans lequel on fait le vide, **caractérisé en ce que** la structure de cathode est une structure de cathode selon l'une quelconque des revendications 17 à 20.

## Patentansprüche

1. Verfahren zum Herstellen von Nanostrukturen (104; 404; 604; 704; 804) an einem Träger, umfassend die folgenden Schritte:
- Bereitstellen eines Trägers, welcher an einer seiner Flächen eine Oberflächenschicht (101; 401; 601; 701; 801) umfasst;
- Bedecken der Oberflächenschicht mit einer Katalysatorschicht (102; 202; 402; 602; 702; 802), welche gemäß einem Muster strukturiert ist, welches Zonen der von dem Katalysator bedeckten Oberflächenschicht und Zonen der Oberflächenschicht freilegt, welche nicht von dem Katalysator bedeckt sind, wobei die Oberflächenschicht eine Barriereschicht für die Diffusion des Katalysators in Richtung des Trägers ist;
- Ätzen der Dicke der Oberflächenschicht (101; 401; 601; 701; 801) in allen nicht von der Katalysatorschicht bedeckten Zonen unter Verwendung der strukturierten Katalysatorschicht als Maske für das Ätzen, bis die Oberflächenschicht in den nicht von der Katalysatorschicht bedeckten Zonen verschwindet;
- selektives Wachsen von Nanostrukturen (104; 404; 604; 704; 804) an den von dem Katalysator bedeckten Zonen der Oberflächenschicht.

2. Verfahren zum Herstellen von Nanostrukturen nach Anspruch 1, **dadurch gekennzeichnet, dass** die Oberflächenschicht aus einem leitfähigen oder einem Halbleitermaterial besteht und die Nanostrukturen aus einem leitfähigen oder einem Halbleitermaterial bestehen.

3. Verfahren zum Herstellen von Nanostrukturen nach Anspruch 1 oder 2, **dadurch gekennzeichnet, dass** der Träger eine widerstandsfähige Schicht (406; 606; 706; 806) an der Fläche umfasst, welche dazu vorgesehen ist, die Oberflächenschicht (401; 601; 701; 801) zu tragen.

4. Verfahren zum Herstellen von Nanostrukturen nach Anspruch 3, **dadurch gekennzeichnet, dass** der Träger eine Schicht aus leitfähigem Material (403) in Kontakt mit der widerstandsfähigen Schicht umfasst.

5. Verfahren zum Herstellen von Nanostrukturen nach Anspruch 3 oder 4, **dadurch gekennzeichnet, dass** wenigstens ein Abschnitt der Dicke der widerstandsfähigen Schicht in den Zonen geätzt wird oder die Oberflächenschicht geätzt wird.

6. Verfahren zum Herstellen von Nanostrukturen nach einem der Ansprüche 1 bis 5, **dadurch gekennzeichnet, dass** die Strukturierung der Katalysatorschicht gemäß einem Muster durch Fragmentation eines Katalysatorfilms an der Oberflächenschicht erhalten wird.

7. Verfahren zum Herstellen von Nanostrukturen nach Anspruch 6, **dadurch gekennzeichnet, dass** die Fragmentation des Katalysatorfilms an der Oberflächenschicht durch Erhöhung der Temperatur des Katalysatorfilms erhalten wird.

8. Verfahren zum Herstellen von Nanostrukturen nach Anspruch 7, **dadurch gekennzeichnet, dass** die Erhöhung der Temperatur des Katalysatorfilms global ist, beispielsweise durch Glühen.

9. Verfahren zum Herstellen von Nanostrukturen nach Anspruch 7, **dadurch gekennzeichnet, dass** die Erhöhung der Temperatur des Katalysatorfilms an der Oberfläche lokalisiert ist, beispielsweise durch Laserbestrahlung oder durch Plasmawirkung.

10. Verfahren zum Herstellen von Nanostrukturen nach einem der Ansprüche 6 bis 9, **dadurch gekennzeichnet, dass** die Oberflächenschicht aus einem Material besteht, welches die Fragmentation des Katalysatorfilms fördert.

11. Verfahren zum Herstellen von Nanostrukturen nach Anspruch 6, **dadurch gekennzeichnet, dass** die Fragmentation des Katalysatorfilms an der Oberflächenschicht durch Techniken eines inhomogenen Trockenätzens oder Nassätzens des Katalysatorfilms erhalten wird.

12. Verfahren zum Herstellen von Nanostrukturen nach einem der Ansprüche 1 bis 11, **dadurch gekennzeichnet, dass** das Muster der strukturierten Katalysatorschicht vor dem Ausführen des Schritts des Ätzens der Oberflächenschicht angepasst wird.

13. Verfahren zum Herstellen von Nanostrukturen nach Anspruch 12, **dadurch gekennzeichnet, dass** das Muster der Katalysatorschicht durch Ätzen der Katalysatorschicht angepasst wird.

14. Verfahren zum Herstellen von Nanostrukturen nach einem der Ansprüche 1 bis 13, **dadurch gekennzeichnet, dass** das Muster der Katalysatorschicht durch Ätzen der Katalysatorschicht nach dem Ausführen des Ätzschritts der Oberflächenschicht angepasst wird.

15. Verfahren zum Herstellen von Nanostrukturen nach einem der Ansprüche 1 bis 14, **dadurch gekennzeichnet, dass** das selektive Wachsen der Nanostrukturen an dem Katalysator durch chemisches Anlagern aus der Dampfphase (CVD) durchgeführt wird.

16. Verfahren zum Herstellen von Nanostrukturen nach einem der Ansprüche 1 bis 15, **dadurch gekennzeichnet, dass** der Schritt des Ätzens der Oberflächenschicht nach dem Schritt des selektiven Wachsens der Nanostrukturen ausgeführt wird.

17. Kathodenstruktur, umfassend:
- einen Träger (600; 700; 800);
- eine leitfähige Schicht, welche eine Kathode (603; 703; 803) an dem Träger bildet;
- wenigstens eine Elektronen-Emitterzone, umfassend Elektronen-Emitternanostrukturen (604; 704; 804), welche ausgehend von einer Katalysatorschicht (602; 702; 802) gebildet sind, welche eine Barriereschicht (601; 701; 801) für die Diffusion des Katalysators bedeckt, wobei die Barriereschicht von einer widerstandsfähigen Schicht getragen ist, wobei die Nanostrukturen mit der leitfähigen Schicht elektrisch verbunden sind, wodurch eine Kathode mittels der Barriereschicht und der widerstandsfähigen Schicht gebildet ist;
- eine metallische Schicht, welche ein Extraktionsgitter (615; 715; 815) zum Extrahieren der von den Nanostrukturen emittierten Elektronen bildet;
wobei die Struktur der Kathode **dadurch gekennzeichnet ist, dass** die Nanostrukturen elektrisch unabhängige Nanostrukturen sind, welche durch Strukturieren der Katalysatorschicht gemäß einem Muster erhalten werden, welches gefüllte Zonen umfasst, in welchen der Katalysator vorliegt, getrennt durch Zonen, in welchen der Katalysator nicht vorliegt, wobei die gefüllten Zonen der Katalysatorschicht Wachstumszonen für die Nanostrukturen bilden, wobei die Barriereschicht in allen nicht von dem Katalysator bedeckten Zonen abwesend ist und derart geätzt ist, dass voneinander getrennte Inseln gebildet sind, wobei jede Nanostruktur ihre eigene Insel aufweist.

18. Kathodenstruktur nach Anspruch 17, wobei die eine Kathode (703) bildende leitfähige Schicht am Boden von wenigstens einer Vertiefung angeordnet ist, welche in einer Schicht aus elektrisch isolierendem Material (711) gebildet ist, wobei die eine Kathode bildende leitfähige Schicht die widerstandsfähige Schicht trägt, welche wiederum die Elektronen-Emitterzone trägt, welche die Nanostrukturen (704) umfasst, und wobei die obere Fläche der Schicht aus elektrisch isolierendem Material (711) die metallische Schicht trägt, welche das Extraktionsgitter (715) bildet.

19. Kathodenstruktur nach Anspruch 17, wobei die eine Kathode (603) bildende leitfähige Schicht und die Elektronen-Emitterzone, umfassend Nanostrukturen (604), lateral bezüglich einander angeordnet und durch die widerstandsfähige Schicht (606) getrennt sind, wobei die ein Extraktionsgitter (615) bildende metallische Schicht von der eine Kathode (603) bildenden leitfähigen Schicht durch eine elektrisch isolierende Schicht (611) getrennt ist.

20. Kathodenstruktur nach Anspruch 17, wobei eine Schicht aus elektrisch isolierendem Material (811) an ihrer unteren Fläche die ein Extraktionsgitter (815) bildende metallische Schicht trägt, welche in zwei Abschnitte unterteilt ist und die Schicht aus eine Kathode (803) bildendem leitfähigem Material umgibt, welche an der oberen Fläche der Schicht aus elektrisch isolierendem Material (811) angeordnet ist, wobei die eine Kathode (803) bildende leitfähige Schicht die widerstandsfähige Schicht trägt, welche wiederum die Elektronen-Emitterzone trägt.

21. Feldemissions-Flachbildschirm, umfassend eine Kathodenstruktur und eine Anode, welche von einer Lumineszenzschicht bedeckt ist, wobei die Anode gegenüber der Kathodenstruktur angeordnet ist und die Anode und die Kathodenstruktur durch einen Raum getrennt sind, in welchem ein Vakuum hergestellt ist, **dadurch gekennzeichnet, dass** die Kathodenstruktur eine Kathodenstruktur nach einem der Ansprüche 17 bis 20 ist.

## Claims

1. Process for making nanostructures (104; 404; 604; 704; 804) on a support, the process comprising the following steps:
- supply of a support comprising a surface layer (101; 401; 601; 701; 801) on one of its faces;
- covering of the surface layer by a catalyst layer (102; 202; 402; 602; 702; 802) structured according to a pattern exposing areas of the surface layer covered by the catalyst and areas of the surface layer not covered by the catalyst, the surface layer being a barrier layer to diffusion of the catalyst towards the support;
- etching of the thickness of the surface layer (101; 401; 601; 701; 801) in all the areas not covered by the catalyst layer by using the structured catalyst layer as an etching mask, until the surface layer disappears in the areas not covered by the catalyst layer;
- selective growth of nanostructures (104; 404; 604; 704; 804) on the areas of the surface layer covered by the catalyst.

2. Process for making nanostructures according to claim 1, **characterized in that** the surface layer is made of a conducting or semi conducting material and the nanostructures are made of a conducting or semi conducting material.

3. Process for making nanostructures according to claim 1 or 2, **characterized in that** the support comprises a resistive layer (406; 606; 706; 806) on the face that will support the surface layer (401; 601; 701; 801).

4. Process for making nanostructures according to claim 3, **characterized in that** the support comprises a layer made of a conducting material (402; 602; 702; 802) in contact with the resistive layer.

5. Process for making nanostructures according to either claim 3 or 4, **characterized in that** at least part of the thickness of the resistive layer is etched in the areas in which the surface layer is etched.

6. Process for making nanostructures according to any one of claims 1 to 5, **characterized in that** the catalyst layer is structured according to a pattern obtained by fragmentation of a catalyst film on the surface layer.

7. Process for making nanostructures according to claim 6, **characterized in that** the catalyst film on the surface layer is fragmented by increasing the temperature of the catalyst film.

8. Process for making nanostructures according to claim 7, **characterized in that** the temperature of the catalyst film is increased globally, for example by annealing.

9. Process for making nanostructures according to claim 7, **characterized in that** the increase of the temperature of the catalyst film is localized on the surface, for example by laser irradiation or by plasma effect.

10. Process for making nanostructures according to any one of claims 6 to 9, **characterized in that** the surface layer is made of a material facilitating fragmentation of the catalyst film.

11. Process for making nanostructures according to claim 6, **characterized in that** the catalyst film on the surface layer is fragmented using non-homogenous dry or wet etching techniques of the catalyst film.

12. Process for making nanostructures according to any one of claims 1 to 11, **characterized in that** the pattern of the structured catalyst layer is adjusted before performing the etching step of the surface layer.

13. Process for making nanostructures according to claim 12, **characterized in that** the pattern of the catalyst layer is adjusted by etching the catalyst layer.

14. Process for making nanostructures according to any one of claims 1 to 13, **characterized in that** the pattern of the catalyst layer is adjusted by etching of the catalyst layer after performing the etching step of the surface layer.

15. Process for making nanostructures according to any one of claims 1 to 14, **characterized in that** the selective growth of nanostructures on the catalyst is done by chemical vapor phase deposition (CVD).

16. Process for making nanostructures according to any one of claims 1 to 15, **characterized in that** the surface layer etching step is carried out after the step for selective growth of nanostructures.

17. Cathode structure comprising:
- a support (600; 700; 800);
- a conducting layer forming a cathode (603 ;703 ; 803) on the support;
- at least one electron emitting area comprising electron emitting nanostructures (604; 704; 804) formed from a catalyst layer (602; 702; 802) covering a barrier layer (601; 701; 801) to diffusion of the catalyst, the barrier layer being supported by a resistive layer, the nanostructures being electrically connected to the conducting layer forming the cathode through the barrier layer and the resistive layer,
- a metallic layer forming an extraction gate (615; 715; 815) to extract electrons emitted by the nanostructures;
the cathode structure being **characterized in that** the nanostructures are electrically independent nanostructures obtained by structuring the catalyst layer according to a pattern comprising solid areas, in which the catalyst is present, separated by areas in which the catalyst is not present, the solid areas of the catalyst layer forming growth zones for the nanostructures, the barrier layer being absent in all the areas not covered by the catalyst and being etched to form islands separated from each other, each nanostructure having its own island.

18. Cathode structure according to claim 17, wherein the conducting layer forming the cathode (703) is arranged at the bottom of at least one hole formed in a layer made of an electrically insulating material (711), the conducting layer forming the cathode supporting the resistive layer, itself supporting the electron emitting area comprising the nanostructures (704) and the upper face of the layer made of an electrically insulating material (711) supporting the metallic layer forming the extraction gate (715).

19. Cathode structure according to claim 17, wherein the conducting layer forming the cathode (603) and the electron emitting area comprising nanostructures (604) are arranged one at the side of the other and separated by the resistive layer (606), the metallic layer forming the extraction gate (615) being separated from the conducting layer forming the cathode (603) by an electrically insulating layer (611).

20. Cathode structure according to claim 17, wherein a layer of electrically insulating material (811) supports on its upper face the metallic layer forming the extraction gate (815) divided into two parts and surrounding the layer of conducting material forming the cathode (803) located on the upper face of the layer of electrically insulating material (811), the conducting layer forming the cathode (803) supporting the resistive layer, itself supporting the electron emitting area.

21. Field emission flat screen comprising a cathode structure and an anode, covered by a luminescent layer, the anode being arranged facing the cathode structure, and the anode and the cathode structure being separated by a space in which a vacuum is created, **characterized in that** the cathode structure is a cathode structure according to any one of claims 17 to 20.
